Europäisches Patentamt

European Patent Office

Office européen des brevets

(11) Veröffentlichungsnummer: **0 167 732**
**B1**

(12) **EUROPÄISCHE PATENTSCHRIFT**

(45) Veröffentlichungstag der Patentschrift: 05.09.90

(21) Anmeldenummer: 85104961.9

(22) Anmeldetag: 24.04.85

(51) Int. Cl.$^5$: **H 01 L 23/52,** H 01 L 25/16, H 01 L 21/48

(54) Verfahren zur Herstellung eines Basismaterials für eine Hybridschaltung.

(30) Priorität: 27.06.84 CH 3104/84

(43) Veröffentlichungstag der Anmeldung:
15.01.86 Patentblatt 86/03

(45) Bekanntmachung des Hinweises auf die Patenterteilung:
05.09.90 Patentblatt 90/36

(84) Benannte Vertragsstaaten:
AT BE CH DE FR GB IT LI NL SE

(56) Entgegenhaltungen:
EP-A-0 006 810
US-A-3 525 617
US-A-3 846 166

(73) Patentinhaber: CONTRAVES AG
Schaffhauserstrasse 580
CH-8052 Zürich (CH)

(72) Erfinder: Schmidt, Walter, Dr.
Oberwiesenstrasse 73 F
CH-8050 Zürich (CH)
Erfinder: Omura, Sachikazu
Wiesenstrasse 10
CH-8008 Zürich (CH)

## Beschreibung

Die Erfindung betrifft ein Verfahren zur Herstellung eines Basismaterials für eine Hybridschaltung, bestehend aus einem Trägersubstrat mit mehrlagig aufgebrachten, elektrisch gegeneinander isolierten und jeweils durch geeignete Mittel in Chip-Auflageflächen und Leiterbahnen unterteilbaren Metallschichten.

Durch die US-A-3,846,166 ist ein Verfahren zur Herstellung von integrierten Schaltungen mit mehrlagigen Leiterbahnführungen bekannt. Ein Substrat, in der Regel ein Porzellanplättchen, wird mit einem Leiterbahnmuster versehen, darüber eine isolierende Schicht aus Kunstharz gelegt und auf diese eine Metallschicht aufgebracht. In diese oberste Metallschicht wird ein Muster für die Verbindungsstellen eines noch aufzubringenden Leiterbahnmusters geätzt. An diesen bestimmten, als vertikale Verbindungen vorgesehenen Stellen, wird dann bspw. mittels Hitze bzw. Oxydation (Plasmaentladung) die isolierende Harzschicht durchbrochen, wobei das Herstellen einer geeigneten "Böschung" Bedeutung zukommt. Anschliessend wird die oberste Metallschicht mit dem Muster für die Verbindungsstellen wieder entfernt und das eigentliche Leiterbahnmuster aufgebracht. Ueber dieses lässt sich dann wieder eine Kunstharzschicht legen und der gleiche Vorgang kann zur Herstellung einer dritten Lage verwendet werden. Weitere Lagen können in der gleichen Weise aufgebaut werden. Dieses Vorgehen kann man auch für Hybridschaltungen anwenden.

Solcherart Verfahren zum Entwerfen und Herstellen von Hybridschaltungen erfordern eine aufwendige Entwicklung und auch eine kostenaufwendige, technische Realisierung. Dies ergibt sich insbesondere bei spezifischen Schaltungs-Anforderungen und aufgrund der Vielzahl unterschiedlicher Herstellungsschritte. Die bekannten Hybridbausteine eignen sich aus wirtschaftlichen Gründen ausschliesslich für relativ grosse Stückzahlen, wobei sie jedoch gegenüber den anderen, bekannten elektronischen Bausteinen den Vorteil einer hohen Packungsdichte und Zuverlässigkeit aufweisen.

Der Erfindung liegt deshalb die Aufgabe zugrunde ein universell verwendbares Hybrid-Basismaterial zu schaffen, mittels welchem unter Beibehaltung einer möglichst hohen Packungsdichte auf wirtschaftliche Weise, durch geringfügige Modifikationen, individuelle elektrische Schaltungen möglich sind.

Die Aufgabe wird durch die in den Patentansprüchen 1 und 2 angegebenen Ausführungsformen gelöst. Weiterbildungen der Erfindung ergeben sich aus den abhängigen Ansprüchen.

Das erfindungsgemässe, programmierbare Hybrid-Substrat kann unter Benutzung der an sich bekannten Verfahren und Techniken hergestellt und als Basismaterial gelagert werden, wodurch die hohen Einmalkosten für schaltungsspezifische Konstruktionsarbeiten und Werkzeuge entfallen. Ein weiterer Vorteil ist, dass dieses Hybrid-Substrat eine hohe Packungsdichte und somit kurze Verbindungsleiter gewährleistet und dadurch eine hohe Signalverarbeitungs-Geschwindigkeit zulässt. Als weiterer Vorteil wird angesehen, dass durch die Programmierbarkeit des Hybrid-Substrates mannigfaltige Schaltungen realisiert werden können, die aufgrund stets identischem Layout der Oberflächenstruktur nahezu kopiersicher sind.

Die Erfindung wird nun an einigen Beispielen und mit Hilfe der unten aufgeführten Figuren erklärt. Die Beispiele II und III fallen nicht in den Schutzumfang.

Fig. 1 ein perspektivisch in Schnittansicht dargestelltes Substrat-Teilstück mit einer ersten Metallschicht,

Fig. 2 das Substrat-Teilstück gemäss Fig. 1 nach einem ersten Bearbeitungsschritt der ersten Metallschicht,

Fig. 3 das Substrat-Teilstück gemäss Fig. 2 mit einer ersten Isolierschicht,

Fig. 4 das Substrat-Teilstück gemäss Fig. 3 mit einer zweiten Metallschicht,

Fig. 5 ein erstes Beispiel eines Hybrid-Substrates, welches unter Verwendung des Substrat-Teilstückes gemäss Fig. 1-4 hergestellt ist,

Fig. 6-8 ein zweites Beispiel eines Hybrid-Substrates, welches unter Verwendung des Substrat-Teilstückes gemäss Fig. 1-4 hergestellt wurde,

Fig. 9-13 ein weiteres, in verschiedenen Stadien dargestelltes Substrat-Teilstück,

Fig. 14-16 ein drittes Beispiel eines Hybrid-Substrates, welches unter Verwendung des Substrat-Teilstückes gemäss Fig. 9-13 hergestellt ist,

Fig. 17-20 ein weiteres, in verschiedenen Stadien dargestelltes Substrat-Teilstück,

Fig. 21-23 ein viertes Beispiel eines Hybrid-Substrates, welches unter Verwendung des Substrat-Teilstückes gemäss Fig. 14-16 hergestellt ist,

Fig. 24 eine Perspektive des Basismaterials für eine Hybridschaltung mit den schematisch dargestellten Kontaktstellen und Chip-Auflageflächen.

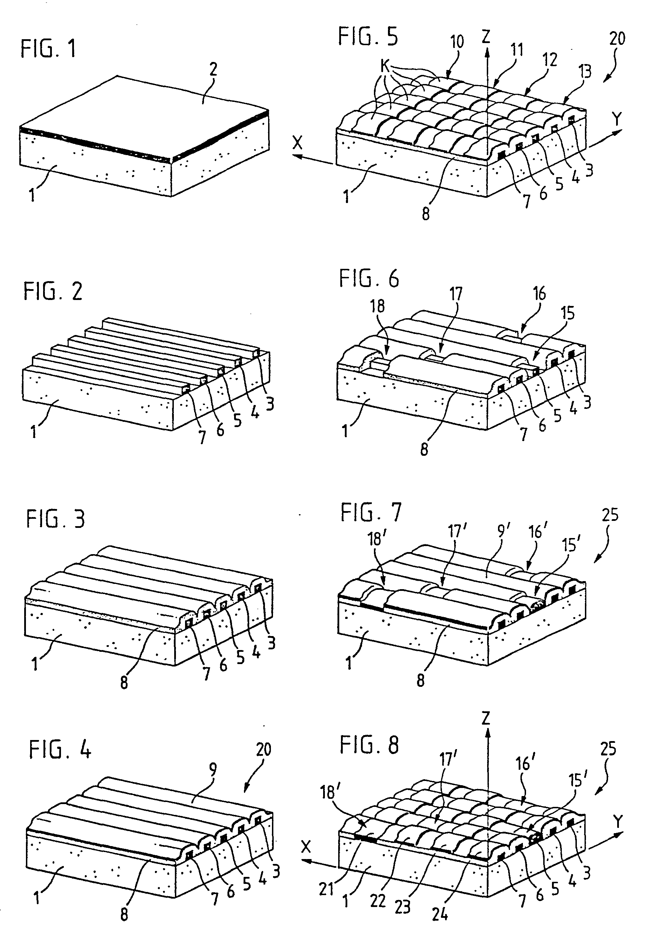

In Fig. 1 ist mit 1 ein elektrisch isolierendes und als Trägerelement vorgesehenes Substrat bezeichnet, auf welchem eine erste Metallschicht 2 aufgedampft oder aufgestäubt ist. Die Metallschicht 2 wird nach dem an sich bekannten photolitographischen Verfahren der Halbleitertechnik derart geätzt, dass, wie in Fig. 2 dargestellt, eine erste Gruppe parallel zueinander angeordnete Leiterbahnen 3, 4, 5, 6, und 7 entsteht. Auf die erste Leiterbahnen-Gruppe 3 bis 7 wird eine in Fig. 3 dargestellte und mit 8 bezeichnete erste Isolierschicht aufgebracht. Diese erste Isolierschicht 8 dient als eine die Leiterbahnen 3 bis 7 elektrisch isolierende Schutzschicht, auf welche, wie in Fig. 4 dargestellt, eine zweite Metallschicht 9 aufgebracht ist.

Schaltungsbeispiele von dem in den Figuren 1, 2, 3 und 4 dargestellten und im wesentlichen aus den Elementen 1 bis 9 gebildeten und in den Figuren 4 und 5 in seiner Gesamtheit mit 20 bezeichneten Hybrid-Substrat werden nachstehend beschrieben.

### Beispiel I

Hierbei wird, wie in Fig. 5 dargestellt, die zweite Metallschicht 9 derart geätzt, dass eine zweite Gruppe parallel zueinander angeordneter Leiterbahnen 10, 11, 12 und 13 entsteht. Die Leiterbahnen 10 bis 13 sind im wesentlichen quer zu den aus der ersten Metallschicht 2 geätzten Leiterbahnen 3 bis 7 orientiert. In der flächigen Projektion der kreuzweise übereinander liegenden und entsprechend geätzten Leiterbahnen 3 bis 7 und 10 bis 13 entstehen Kontaktstellen K, die durch die erste Isolierschicht 8 voneinander elektrisch isolierend getrennt sind. In Fig. 5 ist zur besseren Uebersicht nur eine Gruppe der Kontaktstellen K bezeichnet. Bei dem Ausführungsbeispiel gemäss Fig. 5 besteht die Isolierschicht 8 aus polykristallinem, hochisolierendem Silizium und die erste und zweite Metallschicht 2,9 für die oberen und unteren Leiterbahnen 3 bis 7 sowie 10 bis 13 aus dem in der Halbleitertechnik üblicherweise verwendetem Aluminium. Unter Berücksichtigung dieser Merkmale besteht hierbei die Möglichkeit mittels eines fokussierten Laserstrahls durch lokale Erhitzung der zu kontaktierenden Kontaktstellen K eine elektrisch optimal leitende Aluminium-Silizium-Legierung zu erzeugen.

### Beispiel II

Ausgehend von dem in Fig. 3 dargestellten und aus den Elementen 1 bis 8 gebildeten Hybrid-Substrat werden vor dem Aufbringen der zweiten Metallschicht an beliebig, programmartig vorbestimmten Stellen aus der ersten Isolierschicht 8, wie in Fig. 6 näher dargestellt, entsprechend ausgebildete Fenster 15, 16, 17 und 18 ausgeätzt. Auf die mit den Fenstern 15 bis 18 versehene erste Isolierschicht 8 wird nunmehr, wie in Fig. 7 dargestellt, die zweite Metallschicht 9' aufgebracht, so dass im Bereich der Fenster 15 bis 18 zwischen den Leiterbahnen 3 bis 7 und der zweiten Isolierschicht 9' elektrische Kontaktstellen 15' bis 18' entstehen. Nach dem Aufbringen der zweiten Metallschicht 9' wird dieselbe derart geätzt, dass, wie in Fig. 8 dargestellt, quer zu den ersten Leiterbahnen 3 bis 7 orientierte, elektrisch isoliert voneinander getrennte Leiterbahnen 21, 22, 23 und 24 entstehen.

Bei dem Beispiel II gemäss den Figuren 6, 7 und 8 dient das aus den wesentlichen Elementen 1 bis 9' gebildete Trägerelement (Fig. 3) als Basismaterial und wird erst nach sachbezogener Festlegung der im wesentlichen mittels der Fenster 15 bis 18 gebildeten Kontaktstellen 15' bis 18' sowie der Herstellung einer entsprechenden Aetzmaske (nicht dargestellt) zu dem in Fig. 7, 8 in seiner Gesamtheit mit 25 bezeichneten Hybrid-Substrat verarbeitet.

### Beispiel III

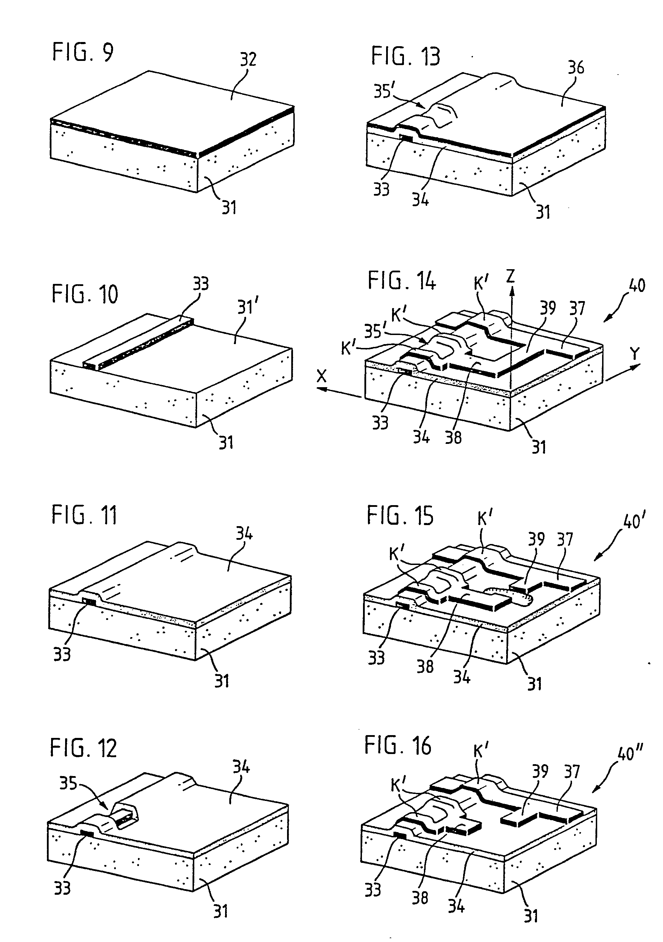

Bei diesem Beispiel wird ausgehend von einem mit einer ersten Metallschicht 32 versehenen Substrat 31 (Fig. 9) die erste Metallschicht 32 derart geätzt, dass, wie in Fig. 10 dargestellt, mindestens eine Leiterbahn 33 entsteht. Auf die Leiterbahn 33 sowie auf die Fläche 31' des Substrats 31 wird nunmehr eine erste Isolierschicht 34 (Fig. 11) aufgebracht. Aus der Isolierschicht 34 wird mindestens ein Fenster 35 geätzt (Fig. 12) und anschliessend, wie in Fig. 13 dargestellt, auf die Elemente 31, 33, 34 und 35 eine zweite Metallschicht 36 aufgebracht. Hierbei wird im Bereich des Fensters 35 zwischen der Leiterbahn 33 und der zweiten Metallschicht 36 eine Kontaktstelle 35' gebildet. Nach dem Aufbringen der zweiten Metallschicht 36 wird dieselbe derart geätzt, dass quer zu der ersten Leiterbahn 33 orientierte und, wie in Fig. 14 dargestellt, durch einen Steg 39 miteinander in Verbindung stehende Leiterbahnen 37 und 38 entstehen. Die von der ersten Leiterbahn 33 und von den zweiten Leiterbahnen 37 und 38 gebildeten und durch die erste Isolierschicht 34 elektrisch isolierend voneinander getrennten Kontaktstellen K' werden anschliessend als elektrische Verbindungen durchkontaktiert.

Bei dem vorstehend beschriebenen Beispiel III dient das in Fig. 14 in seiner Gesamtheit mit 40 bezeichnete Hybrid-Substrat als vorgefertigtes Basismaterial. Der Endzustand des mit 40' beziehungsweise mit 40'' bezeichneten Hybrid-Substrates wird hierbei in der Weise erreicht, dass beispielsweise nichtbenötigte, die im wesentlichen die parallel zueinander orientierten Leiterbahnen 37 und 38 verbindenden Stege 39, gemäss Fig. 15 durch Laser, oder aber, wie in Fig. 16 dargestellt, durch Aetzen unterbrochen oder entfernt werden.

### Beispiel IV

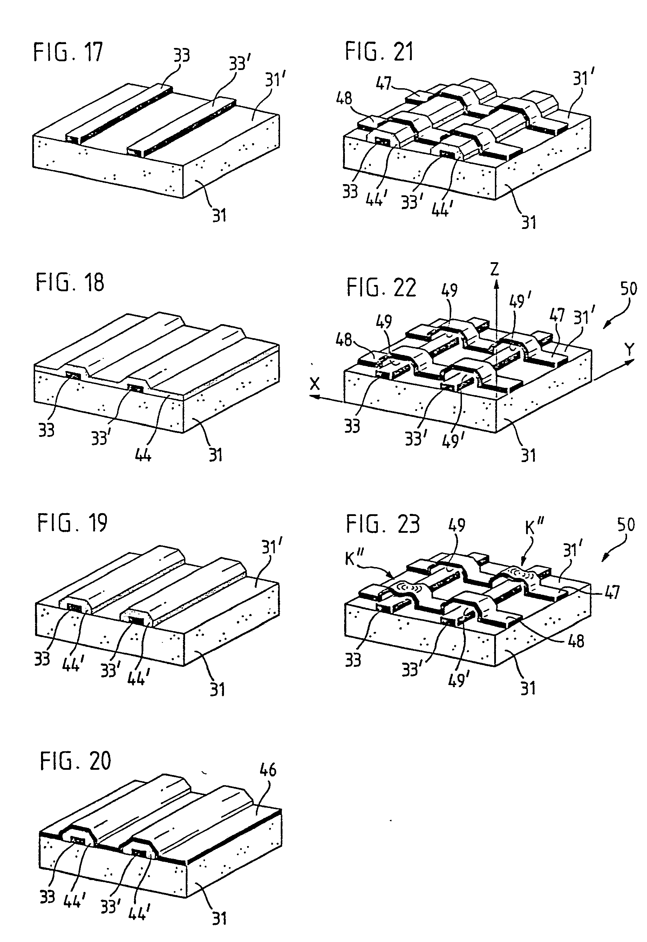

Ausgehend von dem in Fig. 9 dargestellten und im wesentlichen aus dem Substrat 31 und der ersten Metallschicht 32 gebildeten Trägerelement wird bei diesem Beispiel die erste Metallschicht 32 derart geätzt, dass, wie in Fig. 17 dargestellt, zwei parallel zueinander angeordnete Leiterbahnen 33, 33' entstehen. Eine anschliessend aufgebrachte erste Fotolackschicht 44 (Fig. 18) wird, wie in Fig. 19 dargestellt, in einzelne, die beiden Leiterbahnen 33, 33' elektrisch isolierende Fotolack-Brückenteile 44' unterteilt. Auf die Brückenteile 44' sowie auf die Fläche 31' des Substrates 31 wird, wie in Fig. 20 dargestellt, eine zweite, die beiden Brückenteile 44' sowie die Fläche 31' kontaktierende Metallschicht 46 aufgebracht, welche Metallschicht 46 anschliessend durch eine entsprechende Aetzung in einzelne, quer zu den Leiterbahnen 33, 33' orientierte Leiterbahnen 47, 48 unterteilt (Fig. 21) wird. Mittels geeigneter Mittel werden die aus der Fotolackschicht 44 gebildeten Brückenteile 44' entfernt, so dass, wie in Fig. 22 dargestellt, zwischen den einzelnen Leiterbahnen 33, 33' sowie 47, 48 jeweils ein Zwischenraum 49, 49' entsteht.

Bei dem vorstehend beschriebenen Beispiel IV dient das in Fig. 22 in seiner Gesamtheit mit 50 bezeichnete Hybrid-Substrat ebenfalls als vorgefertigtes Basismaterial. Der Endzustand des Hybrid-Substrates 50 wird im wesentlichen dadurch erreicht, dass an vorbestimmten, programmierten Kontaktstellen K'' der sich kreuzenden Leiterbahnen 33, 33' und 47, 48 ein elektrischer Kontakt hergestellt und anschliessend auf das Hybrid-Substrat 50 eine elektrisch isolierende Schutzschicht (nicht dargestellt) aufgebracht wird. Hierbei werden die nicht als Kontaktstellen K'' ausgebildeten Zwischenräume 49 und 49' der sich kreuzenden Leiterbahnen 33, 33' sowie 47, 48 elektrisch gegeneinander isoliert. Die Kontaktstellen K'' werden vorzugsweise durch eine Ultraschall-Schweissung hergestellt und die Zwischenräume 49, 49' mit geeignetem Quarz aufgefüllt.

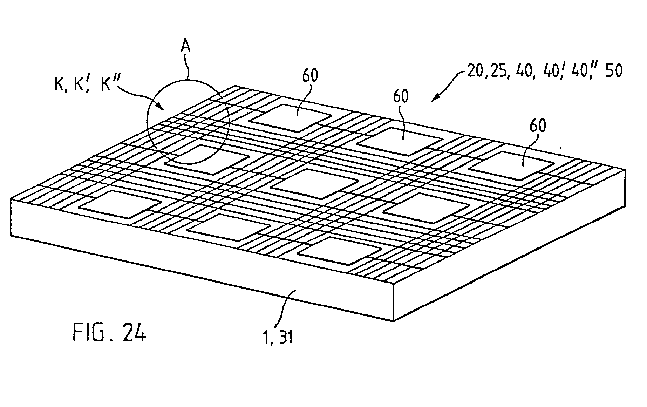

In Fig. 24 ist perspektivisch ein grösseres Teilstück des mit 20, 25, 40, 40', 40'' und 50 bezeichneten Hybrid-Basismaterials dargestellt und man erkennt das Substrat 1 beziehungsweise 31 sowie mit 60 bezeichnete Chip-Auflageflächen. Die durch einen Kreis bezeichnete Stelle A entspricht den hier schematisch dargestellten Kontaktstellen K, K', K'' der sich kreuzenden Leiterbahnen wie sie anhand der Beispiele I, II, III und IV näher beschrieben sind.

Das erfindungsgemässe, vorstehend beschriebene und in den Figuren 1 bis 24 im wesentlichen als Teilstück in grösserem Massstab dargestellte Hybrid-Basismaterial 20, 25, 40, 40', 40'' und 50 kann mittels der bereits bekannten und gut eingeführten Techniken und Verfahren hergestellt werden. Mit den in X- und Y-Richtung im wesentlichen quer zueinander und in Z-Richtung, wie in den Figuren 5, 8, 14 und 22 dargestellt, übereinanderliegend angeordneten Leiterbahnen 3 bis 7; 10 bis 13; 21 bis 24; 33, 37 bis 39; 33, 33' und 47, 48 können bei einer Leiterbahnbreite sowie bei einem Leiterbahnabstand von 25 μ und bei einem 25 mm × 25 mm grossen Hybrid-Basismaterial annähernd 184.000 Kontaktierungsstellen hergestellt und dadurch schaltungstechnisch eine halbe, an sich bekannte Europaform-Karte integriert werden. Die Packungsdichte gegenüber der bekannten, konventionellen Leiterplattentechnik erhöht sich somit um einige Faktoren.

## Patentansprüche

1. Verfahren zur Herstellung eines Basismaterials für eine Hybridschaltung, bestehend aus einem Trägersubstrat mit mehrlagig aufgebrachten, elektrisch gegeneinander isolierten und jeweils durch geeignete Mittel in Bondflächen und Leiterbahnen unterteilte Metallschichten, wobei aus der ersten Metallschicht durch Bildung einer Vielzahl erster Leiterbahnen und aus der zweiten Metallschicht durch Bildung einer Vielzahl die ersten Leiterbahnen kreuzende zweite Leiterbahnen eine Vielzahl Kreuzungspunkte gebildet werden, dadurch gekennzeichnet, dass zwischen den Leiterbahnebenen aus der ersten und zweiten Metallschicht eine in ein elektrisch leitfähiges Material umwandelbare Isolierschicht aus poly-kristallinem, isolierendem Silizium verwendet wird, sodass zur Erreichung eines im Bereich der Kreuzungspunkte anzulegenden elektrischen Kontakts, ein fokussierter Laserstrahl verwendet werden kann.

2. Verfahren zur Herstellung eines Basismaterials für eine Hybridschaltung, bestehend aus einem Trägersubstrat mit mehrlagig aufgebrachten, elektrisch gegeneinander isolierten und jeweils durch geeignete Mittel in Bondflächen und Leiterbahnen unterteilte Metallschichten, wobei aus der ersten Metallschicht durch Bildung einer Vielzahl erster Leiterbahnen und aus der zweiten Metallschicht durch Bildung einer Vielzahl die ersten Leiterbahnen kreuzende zweite Leiterbahnen eine Vielzahl Kreuzungspunkte gebildet werden, dadurch gekennzeichnet, dass zwischen den Leiterbahnebenen aus der ersten und zweiten Metallschicht eine Fotolackisolierschicht verwendet wird, welche nachträglich mittels geeigneter Mittel soweit entfernt wird, dass an den Kreuzungsstellen der einzelnen Leiterbahnen jeweils ein Zwischenraum entsteht, sodass zur Erreichung eines im Bereich der Kreuzungspunkte anzulegenden elektrischen Kontakts, ein mindestens eine Leiterbahn verformendes Mittel verwendet werden kann.

3. Verfahren nach Anspruch 2, dadurch gekennzeichnet, dass als Photolackisolierschicht ein Polyimid verwendet wird.

## Revendications

1. Procédé de réalisation d'un matériau de base pour un circuit hybride, formé d'un substrat de support portant plusieurs couches métalliques isolées électriquement l'une par rapport à l'autre et subdivisées en des surfaces de jonction et des chemins conducteurs par des moyens appropriés, et, partant de la première couche métallique, en formant un grand nombre de premiers chemins conducteurs et à partir de la seconde couche métallique, en formant un grand nombre de seconds chemins conducteurs croisant les premiers chemins conducteurs, on forme un grand nombre de points d'intersection, procédé caractérisé en ce qu'entre les plans des chemins conducteurs de la première et de la seconde couche métallique, on forme une couche d'isolation susceptible d'être transformée en un matériau conducteur d'électricité, à partir d'un silicium polycristallin isolant, et pour arriver à un contact électrique au niveau des points d'intersection, on utilise un faisceau-laser focalisé.

2. Procédé de réalisation d'un matériau de base pour un circuit hybride formé d'un substrat de support portant plusieurs couches métalliques isolées électriquement les unes des autres et subdivisées en des chemins conducteurs et des surfaces de liaison, par des moyens appropriés, et partant de la première couche métallique en formant un grand nombre de premiers chemins conducteurs et à partir de la seconde couche métallique en formant un grand nombre de seconds chemins conducteurs croisant les premiers chemins conducteurs, on forme un grand nombre de points d'intersection, procédé caractérisé en ce qu'entre les plans des chemins conducteurs de la première et de la seconde couche métallique, on utilise une couche d'isolation par photolaque qui est enlevée ultérieurement à l'aide de moyens appropriés pour qu'aux points d'intersection des différents chemins conducteurs, il se forme chaque fois un intervalle, si bien que pour réaliser un contact électrique au niveau des points d'intersection, on utilise au moins un moyen formant un chemin conducteur.

3. Procédé selon la revendication 2, caractérisé en ce que la couche d'isolation en photolaque est une polyimide.

## Claims

1. Process for the production of a base material for a hybrid circuit, comprising a carrier substrate with metal layers applied in a plurality of layers, electrically insulated with respect to each other and each divided by suitable means into bond surfaces and strip conductors, a plurality of points of intersection being formed from the first metal layer by the formation of a plurality of first strip conductors and from the second metal layer by the formation of a plurality of second strip conductors crossing the first strip conductors, characterised in that between the strip conductor planes of the first and second metal layers there is used an insulating layer of polycrystalline insulating silicon which can be converted into an electrically conductive material, so that a focussed laser beam can be used to achieve an electrical contact to be provided in the area of the intersection points.

2. Process for the production of a base material for a hybrid circuit, comprising a carrier substrate with metal layers applied in a plurality of layers, electrically insulated with respect to each other and each divided by suitable means into bond surfaces and strip conductors, a plurality of points of intersection being formed from the first metal layer by the formation of a plurality of first strip conductors and from the second metal layer by the formation of a plurality of second strip conductors crossing the first strip conductors, characterised in that between the strip conductor planes of the first and second metal layers there is used a photo resist insulating layer which is subsequently removed by suitable means so that at each point of intersection of the individual strip conductors there is produced an intermediate space so that a means deforming at least one strip conductor can be used to achieve an electrical contact to be applied in the area of the intersection points.

3. Process according to claim 2, characterised in that a polyimide is used as a photo resist insulating layer.

FIG. 1

FIG. 2

FIG. 3

FIG. 4

FIG. 5

FIG. 6

FIG. 7

FIG. 8

FIG. 9

FIG. 13

FIG. 10

FIG. 14

FIG. 11

FIG. 15

FIG. 12

FIG. 16

FIG. 17

FIG. 21

FIG. 18

FIG. 22

FIG. 19

FIG. 23

FIG. 20

FIG. 24